# EUROPEAN PATENT APPLICATION

(11) **EP 4 790 901 A1**
(43) Date of publication of application: **12.08.2026**
(21) Application number: 25156976.0
(22) Date of filing: 10.02.2025
(51) Int. Cl.: H03K 17/0814, H03K 17/12

(54) **SEMICONDUCTOR SWITCHING CIRCUIT AND CONTROL METHOD THEREOF**

(71) Applicant: Hitachi Energy Ltd, 8050 Zürich (CH)
(72) Inventor: Mesemanolis, Athanasios, 8404 Winterthur (CH); Santolaria, Luis, 4600 Olten (CH); Boksteen, Boni Kofi, 5600 Lenzburg (CH); Guillon, David, 8857 Vorderthal (CH)
(74) Representative: Michalski Hüttermann & Partner mbB

(57) **Abstract**

The invention relates to a semiconductor switching circuit (1) and a method to control thereof. The semiconductor switching circuit (1) comprises a plurality of semiconductor switches (11) connected in parallel and each com-prising a gate (111) and a collector (112), and at least one circuit protection component (13) having a current increasable impedance, wherein the gates (111) of the plurality of semiconductor switches (11) are connect-ed in series with the at least one circuit protection component (13), and in response to a failure of at least one of the plurality of semiconductor switches (11), a driving current of the respective gate (111) connected to the at least one circuit protection component (13) increases the impedance of the at least one circuit protection component (13).

## Description

### Technical Field

The invention relates to the technical field of semiconductor device, in particular, a semiconductor switching circuit and a method to control the semiconductor switching circuit.

### Background Art

Semiconductor switches are widely used in power electronics applications to control and regulate electrical currents efficiently. These circuits typically employ semiconductor switches such as insulated gate bipolar transistors, IGBTs, or metal-oxide-semiconductor field-effect transistors, MOSFETs, which are switched on and off by applying voltage or current to their gate terminals.

In conventional semiconductor switching circuits, multiple semiconductor switches are often connected in parallel and in series to increase current and voltage handling capacity, thereby enhancing overall efficiency. However, one of the significant challenges associated with such configurations is the risk of failure of individual semiconductor switches due to excessive electrical stress, overheating, or manufacturing defects. When a failure occurs in one of the semiconductor switches, it can result in an imbalance in current distribution, leading to thermal runaway, increased circuit damage, and, in extreme cases, complete system failure.

Modern high-voltage, high-power applications that incorporate large stacks of serially and parallelly connected semiconductor switching modules typically require a Short Circuit Failure Mode, SCFM, capability. During operation, a failed module must remain in a low-impedance state to ensure continuous current flow for a long term until scheduled maintenance is performed or for at least a few minutes until secondary protection measures, such as a mechanical bypass, are implemented. SCFM capability, particularly for long-term operation, is crucial for the reliability of high-power applications and has a significant impact on the overall longevity of the system.

However, issues arise when a failure occurs in a single semiconductor switch within a module where multiple switches are connected in parallel. Since the gate of the failed switches is shorted creating a low impedance path, it becomes impossible to raise the gate voltage level and activate the parallel-connected switches. As a result, the entire module current is concentrated at the failed switch's location, leading to an extremely high current density. This localized current surge can cause excessive overheating, potentially fusing the contact and compromising the system's SCFM capability.

Therefore, there remains a strong need to provide an improved semiconductor switching circuit that ensures enhanced SCFM functionality and maintains stable circuit operation without necessitating complex external control mechanisms.

### Summary of invention

It is therefore an object of the invention to provide an improved semiconductor switching circuit and corresponding control method which can selectively block a failed switch, maintain stable circuit operation during a failure and enhances long term Short Circuit Failure Mode, SCFM, functionality.

The object of the invention is solved by the features of the independent claims. Preferred implementations are detailed in the dependent claims.

Thus, the object is solved by a semiconductor switching circuit comprising
a plurality of semiconductor switches connected in parallel and each comprising a gate and a collector, and
at least one circuit protection component having a current increasable impedance, wherein
the gates of the plurality of semiconductor switches are connected in series with the at least one circuit protection component, and
in response to a failure of at least one of the plurality of semiconductor switches, a driving current of the respective gate connected to the at least one circuit protection component increases the impedance of the at least one circuit protection component.

A key point of the invention is an integration of at least one circuit protection component with the current increasable impedance in series with the gates of the plurality of parallel connected semiconductor switches. This design ensures that when a failure occurs in a semiconductor switch of the plurality of semiconductor switches, the impedance of the circuit protection component connected in series with the failed switch increases in response to a driving current, effectively eliminating a low impedance path created by a shorted gate and enabling the turning-on of non-failed switches. This mechanism prevents excessive current concentration at the failed switch, thereby enhancing SCFM capability, reliability and robustness of the system.

In this context, the semiconductor switch may be bipolar-type or a MOSFET-type switches. The semiconductor switches may comprise an IGBT, a Gate Turn-Off Thyristor, GTO, an Integrated Gate-Commutated Thyristor, IGCT, and/or other similar devices.

During normal operation of semiconductor switching circuit, the impedance of the circuit protection component may be low and can be increased by the driving current to the gate of the failed semiconductor switch. For example, during a normal operation condition, the impedance of the circuit protection component is typically in the range of a few tenths of an ohm to tens of ohms. In the event of a failure, the impedance can be increased to an order of hundreds of kilo-ohms. Alternatively, in the event of a failure, the impedance can be increased to infinite so that the failed switch is disconnected from the semiconductor switching circuit.

According to an embodiment of the present invention, the circuit protection component comprises a positive temperature coefficient, PTC, characteristics. The circuit protection component may comprise a PTC resistor, or a fuse.

The PTC resistor may exhibit a nonlinear temperature-impedance curve. The PTC resistor may be a thermistor whose resistance increases and saturates as temperature rises while its temperature rises with respect to the current flowing through the PTC resistor. During normal operation of the semiconductor switching circuit, the current supplied to the gate of the semiconductor switch is typically low, keeping the impedance of the PTC resistor low. However, in the event of a failure in one of the semiconductor switches, the driving current flows to the gate of the failed switch, passing through the PTC resistor, which in turn heats up the resistor and increases its impedance. After the impedance of PTC resistor saturates in a high level, it is possible to maintain the high impedance with a low maintaining current level. Furthermore, after the failure is resolved, the impedance of the PTC resistor can decrease by simply stopping the current supply, allowing the circuit to return to normal operation. The PTC resistor can be ceramic PTC or polymer PTC.

The application of PTC resistor provides a resettable circuit protection mechanism to the parallel connected semiconductor switches, which enhances the long-term SCFM capability of the semiconductor switching circuit by isolating a faulty semiconductor switch in real time, preventing damage to the remaining functional switches and ensuring continued circuit operation.

Alternatively, the circuit protection component can be a fuse. In this embodiment, when a failure occurs, the fuse connected in series with the failed switch blows, effectively isolating the failed switch and preventing it from affecting the rest of the circuit. The fuse can be a non-resettable fuse or a resettable fuse according to the practical requirements of the applications.

According to one embodiment of the present invention, the gate of each semiconductor switch is connected in series with an independent circuit protection component. This configuration allows for the selective blocking of any individual semiconductor switch in the circuit without affecting the operation of the remaining switches, thereby enhancing fault isolation and overall system reliability.

Alternatively, the plurality of semiconductor switches may be divided into at least two groups based on practical needs and design requirements. The gates of semiconductor switches within the same group are connected in series with a shared circuit protection component, while different groups are connected via independent circuit protection components. This configuration allows for the isolation of multiple semiconductor switches using a single circuit protection component, thereby enhancing power efficiency and optimizing the overall performance of the circuit.

According to an embodiment of the present invention, the plurality of semiconductor switches may be arranged in at least one semiconductor switching module. Each of the at least one semiconductor switching module may comprise a module gate terminal connecting to the gates of the plurality of the semiconductor switches arranged in the semiconductor switching module.

The modularization of the semiconductor switches further simplifies the circuit design, enhances scalability and allows for easy replacement of faulty modules. The use of a module gate terminal enables centralized gate control, reducing complexity in gate drive routing while maintaining robust switching performance. Hence, the modular design is well-suited for high-voltage and high-power applications, where large stacks of semiconductor switches are required. Each module can be packed with a corresponding module housing.

Optionally, the gates of different semiconductor switches arranged in the same semiconductor switching module are connected to the module gate terminal via different circuit protection components, or the semiconductor switches arranged in the same semiconductor switching module are grouped as a plurality of groups of semiconductor switches, and the gates of different groups of semiconductor switches are connected to the module gate terminal via different circuit protection components.

Therefore, for each semiconductor switching module, the semiconductor switches packed in the module can be connected to its module gate terminal with a corresponding circuit protection component so as to enable the isolation of individual switches and enhance the overall system robustness. Alternatively, the semiconductor switches packed in the module can further be divided into at least two groups and the gates of switches belonging to the same group are connected to the module gate terminal via an independent circuit protection component so as to enable the group control of the switches. By providing individual or grouped circuit protection for different semiconductor switches, the design ensures that the failure of one switch does not disrupt the operation of other switches in the module. This approach improves the circuit's fault tolerance, making it more robust against failures and reducing downtime.

According to an embodiment of the present invention, the at least one semiconductor switching module further comprises a plurality of submodules, each submodule comprises a submodule gate terminal connecting to the module gate terminal, the plurality of semiconductor switches is arranged in the plurality of submodules, and the gates of the semiconductor switches arranged in the same submodule are connected to the module gate terminal via the corresponding submodule gate terminal.

In this embodiment, the switches arranged in each semiconductor switching modules are further packed in submodules, allowing faults localization at the submodule level before they propagate to the entire module, as well as simplifying the maintenance. The application of the submodules further improves the scalability, reliability and efficiency, making it suitable for demanding power systems. Each of the submodules may be packed with a corresponding submodule housing.

Specifically, the gates of different semiconductor switches arranged in the same submodules are connected to the corresponding submodule gate terminal via different circuit protection components. This approach allows each semiconductor switch within the same submodule to have independent fault protection, which minimize the impact of a single switch failure and extends the operation lifetime of the submodule and switching module.

Optionally, the submodule gate terminals of different submodules arranged in the same semiconductor switching module are connected to the module gate terminal via different circuit protection components, or the submodules arranged in the same conductor switching module are grouped as a plurality of groups of submodules, and the submodule gate terminals of different groups of submodules are connected to the module gate terminal via different circuit protection components.

In these embodiments, the circuit protection component can be placed externally to the submodules, allowing for simplified maintenance by enabling the replacement of faulty submodules without modifying the circuit design.

According to an embodiment of the present invention, the semiconductor switching circuit further comprises a gate drive unit, wherein the gates of the plurality of semiconductor switches are connected to the gate drive unit via the at least one circuit protection component, and in response to the failure of at least one of the plurality of semiconductor switches, the gate drive unit is configured to supply the driving current to the circuit protection components connected to the at least one of the plurality of semiconductor switches.

The gate drive unit can be any electronic circuit or module used to control the switching of semiconductor switches. It ensures proper voltage and current levels to turn the switch on or off efficiently. During normal operation, the gate drive unit may send PWM voltage signal and current flows to the gates of the plurality of semiconductor switches to charge the capacitance. Once a failure is detected, the gate drive unit may remain continuously on, providing a high gate voltage level. This forces the driving current to concentrate on the gate of the failed semiconductor switch, causing it to flow through the circuit protection component. As a result, the impedance of the circuit protection component increases, effectively blocking the failed switch and isolating it from the rest of the circuit.

Alternatively, the gate drive unit may be an external gate drive unit specifically designed to provide the driving current. In this embodiment, the circuit may comprise a primary gate drive unit used to control the switching of semiconductor switches, and a secondary gate drive unit dedicated to supply the high gate voltage level and high driving current in case of a failure. In both configurations, the gate drive unit providing the driving current may have the capability to deliver a high current momentarily to increase the impedance of the circuit protection component.

Optionally, the gate drive unit may be configured to detects the failure of the semiconductor switches. The gate drive unit may comprise or in communication with a gate unit controller logic and the gate unit controller logic is configured to detect the failure of any semiconductor switch.

According to an embodiment of the present invention, when the plurality of semiconductor switches is arranged in the at least one semiconductor switching module, each module gate terminal of the at least one semiconductor switching module is connected to the gate drive unit via one of the at least one circuit protection components.

In this embodiment, a corresponding circuit protection component can be provided externally or internally to the semiconductor switching module, which allows for the fault isolation in the module level and the simplified replacement of the complete module without modifying the whole circuit.

Optionally, the circuit may comprise multiple semiconductor switching modules and multiple gate drive unit. ach gate drive unit may be connected to at least one of the modules, either with or without circuit protection components connected in series. This configuration allows for independent control of different modules, enhancing system flexibility and improving fault tolerance by enabling selective isolation of faulty modules while maintaining overall circuit functionality.

According to an embodiment of the present invention, the gate drive unit may be further configured to supply a maintaining current to the circuit protection components connected to the at least one of the plurality of semiconductor switches to maintain the impedance of the circuit protection component during the failure of the at least one of the plurality of semiconductor switches.

In the embodiment where PTC resistors is used as the circuit protection component, once the impedance of the PTC resistor saturates, the gate drive unit may supply the maintaining current to sustain the high impedance of the PTC resistor. The maintaining current is lower than the driving current.

According to an embodiment of the present invention, the semiconductor switching circuit may comprises a high voltage switching component connected between the gates and the collectors of the plurality of semiconductor switches, wherein the high voltage switching component is configured to switch on and to supply a collector current as the driving current to the circuit protection components connected to the at least one of the plurality of semiconductor switches, in response to the failure of the at least one of the plurality of semiconductor switches.

Therefore, once a failure is detected, the high voltage switching component is switched on and supplies the collector current of the semiconductor switches as the driving current to the gate of the failed switches. This configuration leverages the existing collector current as an activation source, thereby reducing dependency on external control circuits and eliminating the need for the gate drive unit to supply high current momentarily. The high voltage switching component can be a high voltage relay, high voltage contactor or other similar devices.

Optionally, when the plurality of semiconductor switches is arranged in the at least one semiconductor switching module, each of the at least one semiconductor switching module further comprises a module collector terminal connecting to the collectors of the plurality of semiconductor switches, and the high voltage switching component is connected between the module gate terminal and the module collector terminal.

The object of the invention is further solved by a method for operating the semiconductor switching circuit as discussed above. The method comprises the steps of:
in response to detecting a failure of at least one of the plurality of semiconductor switches, supplying a driving current to at least one circuit protection component connected to the at least one of the plurality of semiconductor switches so as to increase the impedance of the at least one circuit protection component.

With this approach, the short circuit caused by the failed semiconductor switch is effectively blocked by the corresponding circuit protection component connected to the failed switch. This enables the adjustment of the gate voltage level of the parallel-connected, non-failed switches, preventing excessive concentration of collector currents, ensuring stable operation of the remaining functional switches and enhancing the long term SCFM capability of the circuit.

Optionally, the method further comprises the step of supplying a maintaining current to the at least one circuit protection component to maintain the impedance of the at least one circuit protection component during the failure of the at least one of the plurality of semiconductor switches.

According to an embodiment of the present invention, the step of supplying the driving current to the circuit protection components comprises: providing, by a gate drive unit, a continuous driving voltage to the gates of the plurality of semiconductor switches so as to supply the driving current to the at least one circuit protection component, or supplying, by switching on a high voltage switching component connected between the gates and the collectors of the plurality of semiconductor switches, a collector current as the driving current to the at least one circuit protection component.

Optionally, the method may further comprise the step of detecting, by a gate unit controller logic, the failure of the at least one semiconductor switches. The gate unit controller logic may be included in or in communication with the gate drive unit.

### Brief description of drawings

These and other aspects of the invention will be apparent from and elucidated with reference to the implementations described hereinafter.

In the drawings:
Fig. 1 shows a circuit diagram of an embodiment of a semiconductor switching circuit where parallel connected semiconductor switches are connected in series with a circuit protection component.
Fig. 2 shows a circuit diagram of another embodiment of the semiconductor switching circuit where each semiconductor switches is connected in series with a circuit protection component.
Fig. 3 shows a circuit diagram of another embodiment of the semiconductor switching circuit where the semiconductor switches are arranged in a semiconductor switching module and each connected in series with a circuit protection component to a module gate terminal.
Fig. 4 shows a circuit diagram of another embodiment of the semiconductor switching circuit where the semiconductor switches are grouped, and each group is connected in series with a circuit protection component to the module gate terminal.
Fig. 5 shows a circuit diagram of another embodiment of the semiconductor switching circuit where the semiconductor switches are arranged in multiple submodules and each connected in series with a circuit protection component to a corresponding submodule gate terminal.
Fig. 6 shows a circuit diagram of another embodiment of the semiconductor switching circuit where each submodule is connected in series with a circuit protection component to the module gate terminal.
Fig. 7 shows a circuit diagram of another embodiment of the semiconductor switching circuit where each semiconductor switch is connected in series with a circuit protection component to a gate drive unit.
Fig. 8 shows a circuit diagram of another embodiment of the semiconductor switching circuit where the semiconductor switching module is connected to a gate drive unit.
Fig. 9 shows a circuit diagram of another embodiment of the semiconductor switching circuit where the semiconductor switching module is connected in series with a circuit protection component to a gate drive unit.
Fig. 10 shows a circuit diagram of another embodiment of the semiconductor switching circuit where a high voltage switching module is provided.
Fig. 11 shows a circuit diagram of another embodiment of the semiconductor switching circuit where multiple semiconductor switching modules are connected to the gate drive unit.
Fig. 12 shows a flow chart according to an embodiment of a semiconductor switching circuit controlling method.

### Description of implementations

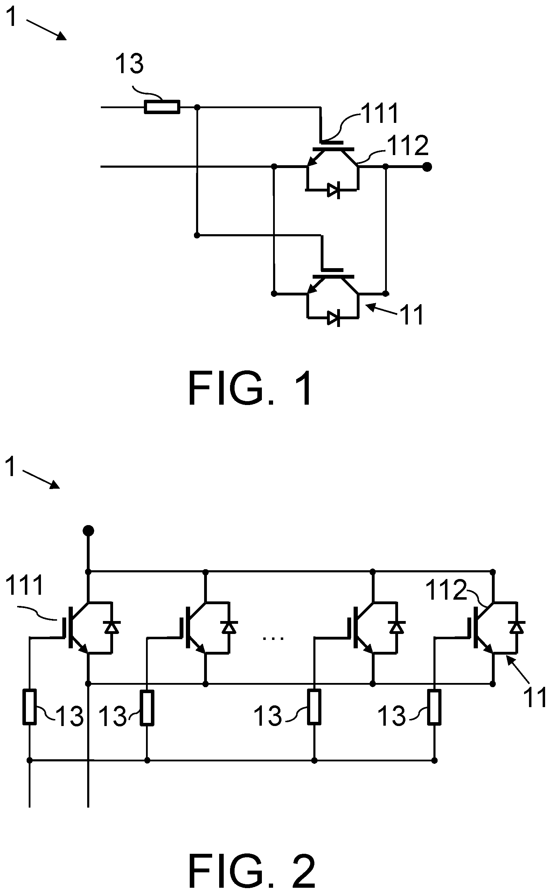

Fig. 1 shows a circuit diagram of an embodiment of a semiconductor switching circuit 1 where parallel connected semiconductor switches 11 are connected in series with a circuit protection component 13.

As shown in Fig. 1, the semiconductor switching circuit 1 comprises a plurality of semiconductor switches 11 connected in parallel and at least one circuit protection component 13 connected in series with semiconductor switches 11. Each of the semiconductor switch 11 comprises a gate 111 and a collector 112. The gates 111 of the semiconductor switches 11 are connected to one end of the circuit protection component 13. The at least one circuit protection component 13 having a current increasable impedance. In response to a failure of at least one of the plurality of semiconductor switches 11, a driving current flows through the at least one circuit protection component 13 to the respective gate 111 and increases the impedance of the at least one circuit protection component 13.

Although not depicted in Fig. 1, each of the semiconductor switches 11 may be connected to an individual circuit protection component 13. Furthermore, it should be noted that Fig. 1 illustrates only one possible circuit configuration of the present invention. In practice, the circuit configuration may include multiple semiconductor switching circuits 1, as shown in Fig. 1, connected in series and/or in parallel.

In this context, the semiconductor switches 11 may be a bipolar-type or MOSFET-type switch. The semiconductor switches 11 may comprise an IGBT, a Gate Turn-Off Thyristor (GTO), an Integrated Gate-Commutated Thyristor (IGCT), and/or other similar devices. Additionally, the semiconductor switches 11 may feature a solder-free, press-pack design, such as a press-pack IGBT, press-pack IGBT with an internal free-wheeling diode switch, or press-pack thyristor. Press-pack semiconductor switches 11 are reliable, durable, and power-efficient, making them well-suited for high-voltage, high-power applications, including high-voltage direct current (HVDC) systems, railways, and industrial power control. Optionally, each semiconductor switches 11 may be packed as an integrated chip, providing a compact and efficient design. Fig.1 illustrates the semiconductor switch 11 as press-pack IGBT with an internal free-wheeling diode switch. However, it should be understood that other semiconductor switches can also be used according to the practical needs.

In an embodiment of the present invention, the circuit protection components 13 may be PTC resistors. The PTC resistor can be ceramic PTC or polymer PTC. Compared to a standard silistor, the PTC resistor exhibits a nonlinear temperature-impedance characteristic. When the temperature of the PTC resistor is below its Curie temperature T_{c}, its impedance remains low and stable, typically within the range of a few to tens of ohms, allowing normal current flow. However, once the temperature exceeds T_{c}, the impedance of the PTC resistor increases significantly, reaching values on the order of hundreds of kilo-ohms and effectively acting as an open circuit. Once the equilibrium is reached, the PTC remains in high impedance mode and the trickle current required the sustain the high impedance is low, therefore allowing the voltage of the PTC resistor to rise. Generally, the Curie temperature T_{c} ranges between 80 to 200 °C, thereby allowing the normal operation temperature of the circuit.

Thus, during normal operation of the semiconductor switching circuit 1, the current supplied to the gate 111 of the semiconductor switches 11 is typically low and is not sufficient to raise the temperature of the PTC resistor, keeping the impedance of the PTC resistor low and stable. Later, in the event of a failure in one of the semiconductor switches 11, the gate 111 of the failed switch is shorted, thereby creating a low impedance circuit. The driving current then increases and rushes to the low impedance path, heating up the PTC resistor to the Curie temperature T_{c} and increases its impedance significantly.

In another embodiment, the circuit protection component can be a fuse. In this embodiment, in the event of a failure in one of the semiconductor switches 11, the increased driving current rushes through the fuse so that the fuse is blown to create an open circuit.

In both embodiments, since the driving current automatically flows to the low-impedance path, there is no need to identify the failed switch in advance, which significantly enhances the real-time response of the circuit protection mechanism. Additionally, during maintenance, the failed switch can be accurately identified by locating either the heated-up PTC resistor or the blown fuse, making the diagnosis and replacement process more efficient and convenient.

Fig. 2 shows a circuit diagram of another embodiment of the semiconductor switching circuit 1 where each of the parallel connected semiconductor switches 11 is connected in series with a circuit protection component 13. As shown in Fig. 2, the gate 111 of each semiconductor switch 11 is connected in series with an independent circuit protection component 13. With this configuration, no matter which semiconductor switch 11 is failed, it is possible to accurately block the respective semiconductor switch 11 via the independent circuit protection component 13 and thereby increasing the reliability of the semiconductor switching circuit 1.

Alternatively, although not depicted in the figures, the plurality of semiconductor switches 11 may be divided into a plurality of groups based on practical needs and design requirements. The gates 111 of semiconductor switches 11 within the same group are connected in series with a shared circuit protection component 13, while different groups are connected via independent circuit protection components 13.

Some embodiments of the present invention may apply a modular design. In other words, the plurality of semiconductor switches 11 may be arranged in at least one semiconductor switching module 10. Each semiconductor switching module 10 may comprise a module gate terminal 101. The gates 111 of the plurality of semiconductor switches 11 arranged in the semiconductor switching module 10 are then connected the module gate terminal 101 for module control.

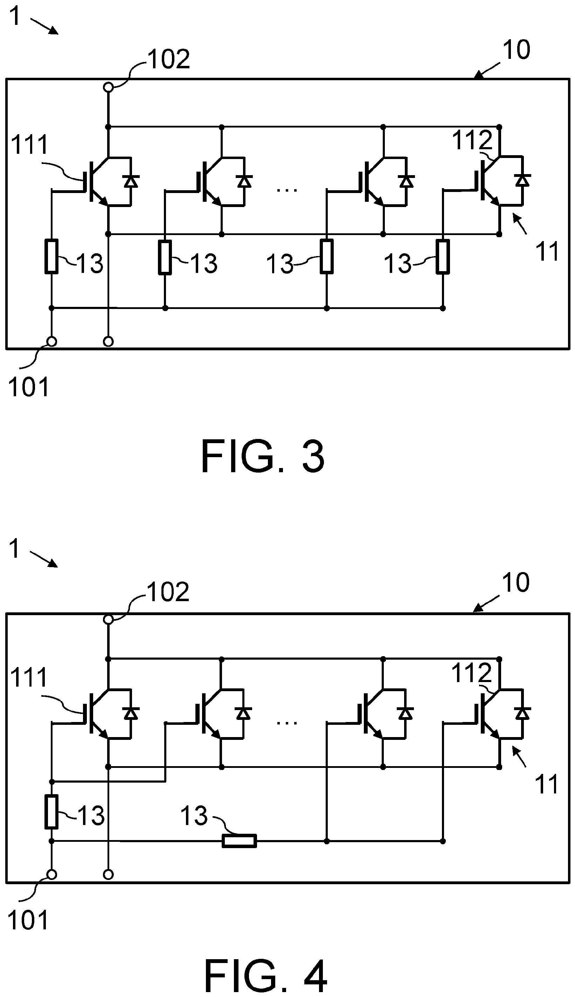

Fig. 3 then shows a circuit diagram of another embodiment of the semiconductor switching circuit 1 where the parallel connected semiconductor switches 11 are arranged in a semiconductor switching module 10. As depicted in Fig.3, each semiconductor switch 11 is connected in series with an independent circuit protection component 13 to a module gate terminal 101.

Alternatively, as shown in Fig.4, the semiconductor switches 11 arranged in the same semiconductor switching module 10 are grouped as a plurality of groups of semiconductor switches 11, and the gates 111 of the semiconductor switches 11 belong to the same group are connected to the module gate terminal 101 via a shared circuit protection component 13.This configuration allows for the circuit protection with reduced number of the circuit protection components 13.

Although not depicted, it is possible to provide the circuit protection component 13 external to the semiconductor switching module 10. In this embodiment, the gates 111 of the plurality of semiconductor switches 11 are connected to an end of the module gate terminal 101 and the other end of the module gate terminal 11 is connected to a corresponding circuit protection component 13.

In some embodiments of the invention, an intermediate layer may be added to enhance the scalability of circuit 1. Specifically, each semiconductor switching module 10 comprises multiple submodules 14, where each submodule 14 includes a submodule gate terminal 141 that connects to the module gate terminal 101. The semiconductor switches 11 are arranged within these submodules 14, and the gates 111 of the semiconductor switches 11 in the same submodule 14 are connected to the module gate terminal 101 via the corresponding submodule gate terminal 141.

This hierarchical configuration provides enhanced circuit protection and simplifies maintenance, as failed submodules 14 can be replaced individually instead of the entire module. Each submodule 14 may contain two to six parallel-connected semiconductor switches 11, allowing for flexible and scalable circuit design.

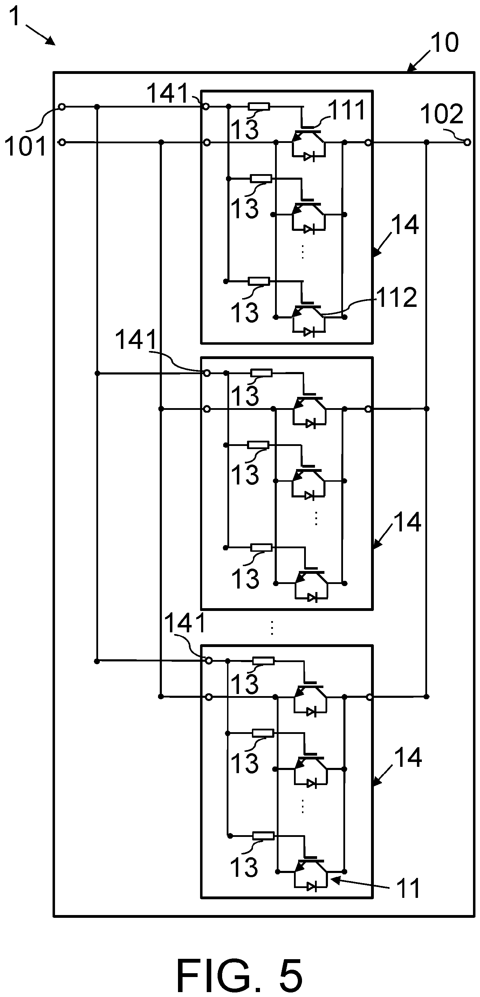

Fig. 5 illustrates a circuit diagram where submodules 14 are employed. As shown in Fig. 5, the semiconductor switches 11 are arranged within multiple submodules 14. Each semiconductor switch 11 within the same submodule 14 is connected in series with an individual circuit protection component 13 to the corresponding submodule gate terminal 141. Although not illustrated, semiconductor switches 11 within the same submodule 14 can also be grouped, with each group being connected in series with a shared circuit protection component 13 to the corresponding submodule gate terminal 141.

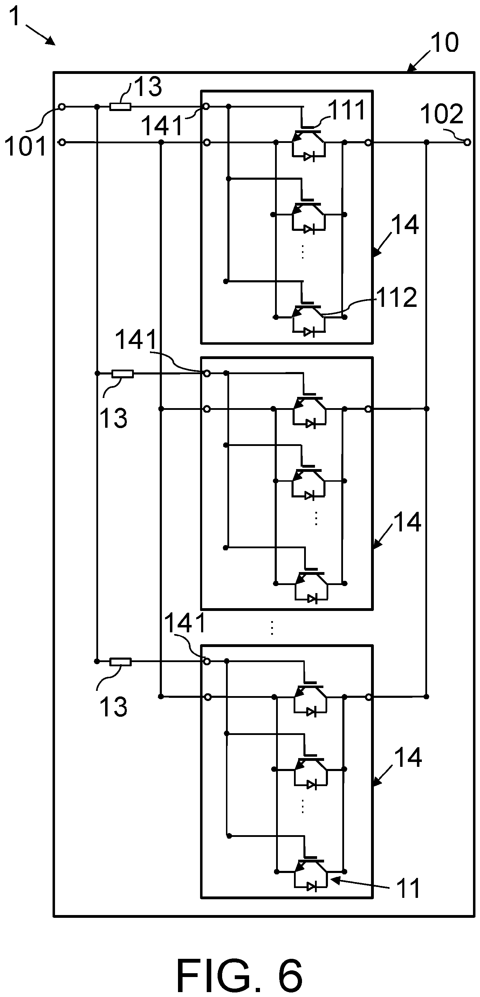

An alternative embodiment is shown in Fig. 6, where the circuit protection components 13 are positioned externally to the submodules 14. In this configuration, the semiconductor switches 11 within the same submodule 14 are directly connected to the corresponding submodule gate terminal 141. Each submodule gate terminal 141 is then connected to the module gate terminal 101 through an individual circuit protection component 13.

By placing the circuit protection component 13 externally, it is shielded from submodule failures and does not experience complete destruction when a submodule 14 fails. This ensures that the circuit protection component 13 retains its properties, maintaining functionality and improving the reliability of the protection mechanism. Alternatively, the submodules 14 can be grouped, with each group of submodules 14 connected in series with a shared circuit protection component 13, further optimizing efficiency.

Furthermore, in some embodiments of the present invention, the circuit 1 may include a gate drive unit 15 connected to the gates 111 of the plurality of semiconductor switches 11. In response to a failure in at least one of the semiconductor switches 11, the gate drive unit 15 is configured to supply the driving current to the circuit protection components 13 connected to the failed switch.

The gate drive unit 15 can either be the same gate drive unit that controls the switching of the semiconductor switches 11, or a dedicated gate drive unit specifically designed for circuit protection purposes. In both cases, the gate drive unit 15 may have the capability to deliver a high current momentarily, ensuring effective failure isolation and maintaining circuit integrity.

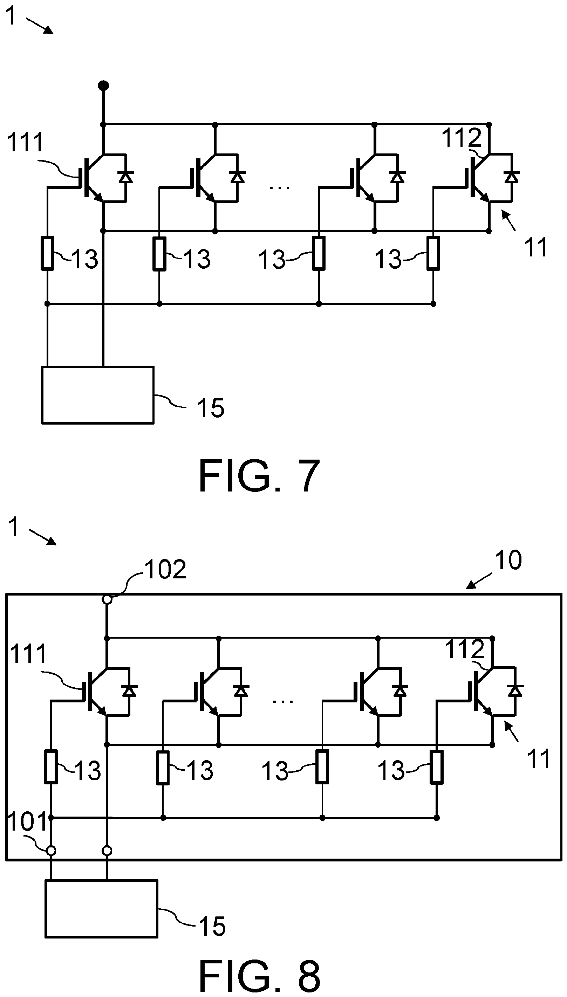

Fig. 7 presents a circuit diagram of an embodiment incorporating the gate drive unit 15. As illustrated in Fig. 7, each semiconductor switch 11 is connected in series with an individual circuit protection component 13 to a gate drive unit 15. The gate drive unit 15 can be implemented as a separate module, distinct from the semiconductor switches 11. The circuit protection components 13 may be installed either within the semiconductor switching module alongside the semiconductor switches 11 or in a separate module together with the gate drive unit 15.

In some embodiments of the present invention, the plurality of semiconductor switches 11 is arranged in at least one semiconductor switching module 10, where each module gate terminal 101 of the semiconductor switching module 10 is connected to the gate drive unit 15 via one of the circuit protection components 13.

Similarly, the gate drive unit 15 can be implemented as a separate module, independent of the semiconductor switching module 10. The circuit protection components 13 can either be installed within the semiconductor switching module or positioned externally in a separate module along with the gate drive unit 15. In the latter configuration, the circuit protection components 13 are shielded from failures occurring within the semiconductor switching module 10, enhancing system reliability.

Fig. 8 illustrates an embodiment where the circuit protection components 13 are placed inside the semiconductor switching module 10. In this configuration, multiple semiconductor switches 11 are first arranged within a semiconductor switching module 10. Each gate 111 of the semiconductor switches 11 is connected to the module gate terminal 101 through an independent circuit protection component 13, and the module gate terminal is subsequently connected to the gate drive unit 15. Alternatively, the semiconductor switches 11 may be grouped, with each group connected to the gate drive unit 15 via a shared circuit protection component 13.

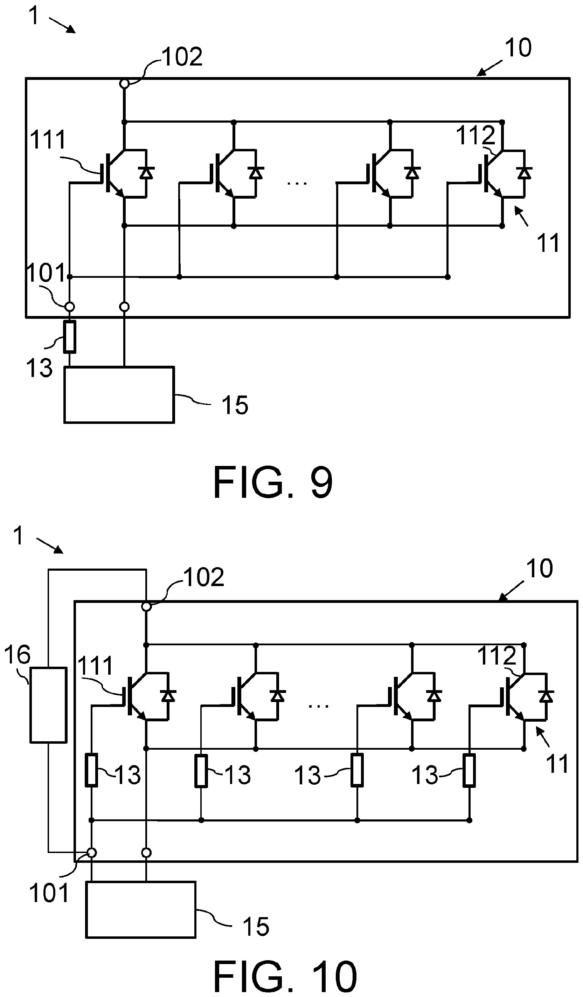

An alternative design is depicted in Fig. 9, where the circuit protection component 13 is placed externally to the semiconductor switching module 10. As shown in Fig. 9, the semiconductor switches 11 are directly connected to the module gate terminal 101, while the module gate terminal 101 is connected in series with a circuit protection component 13 before reaching the gate drive unit 15.

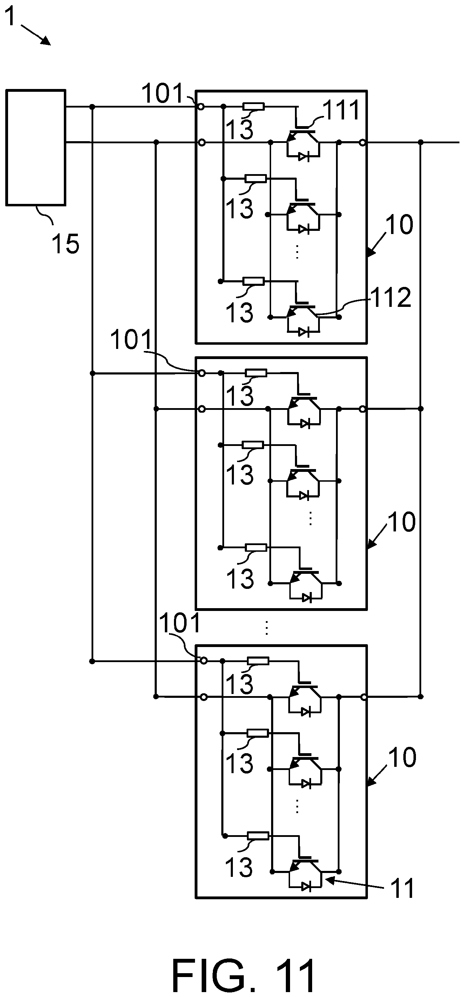

Fig. 11 provides another embodiment where multiple semiconductor switching modules 10 are connected to the gate drive unit 15. Although not explicitly depicted, the circuit 1 may include multiple gate drive units 15, each corresponding to and connected with a semiconductor switching module 10, allowing for independent control and enhanced fault tolerance.

Moreover, although not shown in the drawings, each semiconductor switching module 10 may include a plurality of groups of semiconductor switches, multiple submodules, and/or a group of submodules as discussed above.

In some embodiments of the present invention, the gate drive unit 15 may be further configured to supply a maintaining current to the circuit protection components 13 connected to at least one of the plurality of semiconductor switches 11 to sustain the impedance of the circuit protection component 13 during the failure of at least one of the plurality of semiconductor switches 11. For example, when PTC resistors are used, a trickle current is required to maintain their high-impedance mode during failure.

Additionally, the gate drive unit 15 may include or be in communication with a gate unit controller logic, which is responsible for detecting failures in any semiconductor switch 11.

Beyond supplying driving current via a dedicated gate drive unit 15, the present invention may also utilize the existing collector current of semiconductor switches 11 as the driving current, thereby reducing the power and current supply requirements of the gate drive unit 15.

In this embodiment, the circuit 1 may include a high voltage switching component 16 connected between the gates 111 and the collectors 112 of the plurality of semiconductor switches 11. In response to the failure of at least one of the plurality of semiconductor switches 11, the high voltage switching component 16 is switched on to supply the collector current as the driving current to the circuit protection components 13 connected to at least one of the plurality of semiconductor switches 11.

This embodiment is shown in Fig. 10. As illustrated, the plurality of semiconductor switches 11 is arranged in a semiconductor switching module 10, which includes a module collector terminal 102 connected to the collectors 112 of the plurality of semiconductor switches 11. One end of the high voltage switching component 16 is connected to the module gate terminal 101, while the other end is connected to the module collector terminal 102. Once a failure is detected, the high voltage switching component 16 is switched on, supplying the collector current of the semiconductor switches 11 as the driving current to the gate 111 of the failed switches 11.

The present invention further provides a method for controlling the semiconductor switching component in accordance with any of the configurations discussed above. In response to detecting a failure in at least one of the plurality of semiconductor switches, the method involves supplying, S101, the driving current to at least one circuit protection component connected to the failed switch. This increases the impedance of the circuit protection component, effectively blocking the failed switch and preventing further disruption to the circuit.

Optionally, the method may also include the step of supplying, S102, a maintaining current to the circuit protection component to sustain its high impedance state during the failure. For example, when a PTC resistor is used as the circuit protection component, a maintaining current lower than the driving current may be supplied continuously to keep the PTC resistor in its high-impedance state throughout the failure.

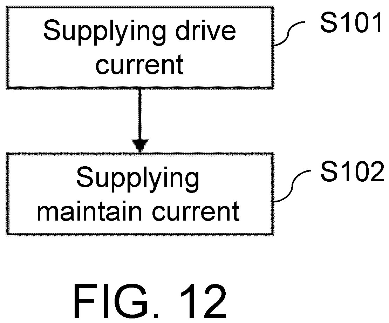

Fig. 12 illustrates a flow chart representing an embodiment of this semiconductor switching circuit control method. Notably, the step of supplying a maintaining current can be omitted if the circuit protection component 13 is a fuse, as a fuse is permanently blown upon failure.

As previously discussed, during normal operation, the gate drive unit 15 sends a PWM voltage signal, allowing current to flow to the gates of multiple semiconductor switches 11 to charge their gate capacitance. Upon failure detection, the gate drive unit 15 may remain continuously on, providing a high gate voltage level that directs the driving current to the gate of the failed switch, leading to the heating or blowing of the circuit protection component.

Alternatively, the high voltage switching component 16 may be activated to utilize the existing collector current as the driving current. In another alternative, the circuit may incorporate a primary gate drive unit to control semiconductor switch operation, and a secondary gate drive unit dedicated to supplying the driving and/or maintaining currents.

Optionally, the method may further include a step of detecting, via a gate unit controller logic, the failure of at least one semiconductor switch. The gate unit controller logic may either be integrated into or communicate with the gate drive unit.

In the event of a semiconductor switch failure, the gate of the failed switch becomes shorted, forming a low-impedance path. Consequently, the output current of the gate drive unit increases, while the gate voltage level of the switches remains low. Thus, the gate unit controller logic can determine that a failure has occurred by detecting an increase in the output current of the gate drive unit. Optionally, the controller logic may also detect failure based on the gate voltage level remaining low across the plurality of semiconductor switches.

While the invention has been illustrated and described in detail in the drawings and foregoing description, such illustration and description are to be considered illustrative or exemplary and not restrictive; the invention is not limited to the disclosed implementations. Other variations to be disclosed implementations can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

1 semiconductor switching circuit
10 semiconductor switching module
101 module gate terminal
102 module collector terminal
11 semiconductor switch
111 gate
112 collector
13 circuit protection component
14 submodule
141 submodule gate terminal
15 gate drive unit
16 high voltage switching component

## Claims

1. A semiconductor switching circuit (1) comprising:
a plurality of semiconductor switches (11) connected in parallel and each comprising a gate (111) and a collector (112), and
at least one circuit protection component (13) having a current increasable impedance, wherein
the gates (111) of the plurality of semiconductor switches (11) are connected in series with the at least one circuit protection component (13), and
in response to a failure of at least one of the plurality of semiconductor switches (11), a driving current of the respective gate (111) connected to the at least one circuit protection component (13) increases the impedance of the at least one circuit protection component (13).

2. The semiconductor switching circuit (1) according to the previous claim, wherein the circuit protection component (13) comprises a positive temperature coefficient, PTC, characteristics and comprises a PTC resistor, or the circuit protection component (13) comprises a fuse.

3. The semiconductor switching circuit (1) according to any one of the previous claims, wherein
the plurality of semiconductor switches (11) is arranged in at least one semiconductor switching module (10), and
each at least one semiconductor switching module (10) comprises a module gate terminal (101) connecting to the gates (111) of the plurality of the semiconductor switches (11) arranged in the semiconductor switching module (10).

4. The semiconductor switching circuit (1) according to the previous claim, wherein
the gates (111) of different semiconductor switches (11) arranged in the same semiconductor switching module (10) are connected to the module gate terminal (101) via different circuit protection components (13), or
the semiconductor switches (11) arranged in the same semiconductor switching module (10) are grouped as a plurality of groups of semiconductor switches (11), and
the gates (111) of different groups of semiconductor switches (11) are connected to the module gate terminal (101) via different circuit protection components (13).

5. The semiconductor switching circuit (1) according to the previous claim 3, wherein
the at least one semiconductor switching module (10) further comprises a plurality of submodules (14),
each submodule (14) comprises a submodule gate terminal (141) connecting to the module gate terminal (101),
the plurality of semiconductor switches (11) is arranged in the plurality of submodules (14), and
the gates (111) of the semiconductor switches (11) arranged in the same submodule (14) are connected to the module gate terminal (101) via the corresponding submodule gate terminal (141).

6. The semiconductor switching circuit (1) according to the previous claim, wherein,
the gates (111) of different semiconductor switches (11) arranged in the same submodules are connected to the corresponding submodule gate terminal (141) via different circuit protection components (13).

7. The semiconductor switching module (10) according to any of the previous two claims, wherein
the submodule gate terminals (141) of different submodules (14) arranged in the same semiconductor switching module (10) are connected to the module gate terminal (101) via different circuit protection components (13), or
the submodules (14) arranged in the same conductor switching module (10) are grouped as a plurality of groups of submodules (14), and
the submodule gate terminals (141) of different groups of submodules (14) are connected to the module gate terminal (101) via different circuit protection components (13).

8. The semiconductor switching circuit (1) according to any one of the previous claims, further comprising:
a gate drive unit (15), wherein
the gates (111) of the plurality of semiconductor switches (11) are connected to the gate drive unit (15) via the at least one circuit protection component (13), and
in response to the failure of the at least one of the plurality of semiconductor switches (11),
the gate drive unit (15) is configured to supply the driving current to the circuit protection components (13) connected to the at least one of the plurality of semiconductor switches (11).

9. The semiconductor switching circuit (1) according to the previous claim and claim 3, wherein
when the plurality of semiconductor switches (11) is arranged in the at least one semiconductor switching module (10),
each module gate terminal (101) of the at least one semiconductor switching module (10) is connected to the gate drive unit (15) via one of the at least one circuit protection components (13).

10. The semiconductor switching circuit (1) according to the previous two claim, wherein
the gate drive unit (15) is further configured to supply a maintaining current to the circuit protection components (13) connected to the at least one of the plurality of semiconductor switches (11) to maintain the impedance of the circuit protection component (13) during the failure of the at least one of the plurality of semiconductor switches (11).

11. The semiconductor switching circuit (1) according to any one of the previous claims, further comprising:
a high voltage switching component (16) connected between the gates (111) and the collectors (112) of the plurality of semiconductor switches (11), wherein
the high voltage switching component (16) is configured to switch on and to supply a collector current as the driving current to the circuit protection components (13) connected to the at least one of the plurality of semiconductor switches (11), in response to the failure of the at least one of the plurality of semiconductor switches (11).

12. The semiconductor switching circuit (1) according to the previous claim and claim 3, wherein
when the plurality of semiconductor switches (11) is arranged in the at least one semiconductor switching module (10),
each of the at least one semiconductor switching module (10) further comprises a module collector terminal (102) connecting to the collectors of the plurality of semiconductor switches (11), and
the high voltage switching component (16) is connected between the module gate terminal (101) and the module collector terminal (102).

13. A method for operating a semiconductor switching circuit (1) according any one of the previous claims, comprising:
in response to detecting a failure of at least one of the plurality of semiconductor switches (11),
supplying (S101) a driving current to at least one circuit protection component (13) connected to the at least one of the plurality of semiconductor switches (11) so as to increase the impedance of the at least one circuit protection component (13).

14. The method according to the previous claim, further comprising:
supplying (S102) a maintaining current to the at least one circuit protection component (13) to maintain the impedance of the at least one circuit protection component (13) during the failure of the at least one of the plurality of semiconductor switches (11).

15. The method according to any one of the previous two claims, wherein
the step of supplying (S101) the driving current to the circuit protection components (13) comprises:
providing, by a gate drive unit (15), a continuous driving voltage to the gates (111) of the plurality of semiconductor switches (11) so as to supply the driving current to the at least one circuit protection component (13), or
supplying, by switching on a high voltage switching component (16) connected between the gates (111) and the collectors (112) of the plurality of semiconductor switches (11), a collector current as the driving current to the at least one circuit protection component (13).
